# EUROPEAN PATENT APPLICATION

(11) **EP 2 043 153 A1**
(43) Date of publication of application: **01.04.2009**
(21) Application number: 07768243.3
(22) Date of filing: 05.07.2007
(51) Int. Cl.: H01L 27/14, H05K 1/02

(54) **WIRING BOARD AND SOLID-STATE IMAGING DEVICE**

(30) Priority: 11.07.2006 JP 2006190475
(71) Applicant: Hamamatsu Photonics K.K., Hamamatsu-shi, Shizuoka 435-8558 (JP)
(72) Inventor: YONETA, Yasuhito, Hamamatsu-shi Shizuoka 435-8558 (JP); SUZUKI, Hisanori, Hamamatsu-shi Shizuoka 435-8558 (JP); KOBAYASHI, Hiroya, Hamamatsu-shi Shizuoka 435-8558 (JP); MURAMATSU, Masaharu, Hamamatsu-shi Shizuoka 435-8558 (JP)
(74) Representative: Frost, Alex John
(86) International application number: PCT/JP2007/063494
(87) International publication number: WO 2008/007613

(57) **Abstract**

Provided are a wiring board capable of mounting either a frontside incident type solid-state imaging element and a backside incident type solid-state imaging element and a solid-state imaging device. The wiring board 1 is a wiring board having a to-be-arranged region 1a at which the solid-state imaging element is arranged, and is provided with a plurality of first electrode pads 12 formed inside the to-be-arranged region 1a and a plurality of second electrode pads 13 formed outside the to-be-arranged region 1a, each of which is electrically connected to each of the first electrode pads 12. Further, the solid-state imaging device mounts the backside incident type solid-state imaging element or the frontside incident type solid-state imaging element on the wiring board 1.

## Description

### Technical Field

The present invention relates to a wiring board for mounting a solid-state imaging element and also relates to a solid-state imaging device.

### Background Art

As a solid-state imaging device in which a solid-state imaging element is mounted on a wiring board, frontside incident type solid-state imaging devices and backside incident type solid-state imaging devices have been known. The frontside incident type solid-state imaging device is provided with a solid-state imaging element having a light detecting portion and a terminal electrode electrically connected to the light detecting portion on one face and also giving the one face as a light receiving face, the solid-state imaging element is mounted on a wiring board so that the other face opposes the wiring board, and the terminal electrode of the solid-state imaging element is connected to an electrode pad of the wiring board by wire bonding (refer, for example, to Patent Document 1).

Further, the backside incident type solid-state imaging device is provided with a solid-state imaging element having a light detecting portion and a terminal electrode electrically connected to the light detecting portion on one face and also giving the other face as a light receiving face, the solid-state imaging element is mounted on a wiring board so that the one face opposes the wiring board, and the terminal electrode of the solid-state imaging element is connected to an electrode pad of the wiring board by bump bonding (refer, for example, to Patent Document 2).

Further, a backside incident type solid-state imaging device is higher in price than a frontside incident type solid-state imaging device because it has a thinned portion on a solid-state imaging element formed. Therefore, in view of a reduction in manufacturing costs, the frontside incident type solid-state imaging element and the backside incident type solid-state imaging element are made in common platform (more specifically, processes before the formation of the thinned portion are made common).
Patent Document 1: Japanese Published Unexamined Patent Application No. Hei-10-107255
Patent Document 2: Japanese Published Unexamined Patent Application No. Hei-6-45574

### Disclosure of the Invention

### Problem to be Solved by the Invention

Incidentally, a frontside incident type solid-state imaging element and a backside incident type solid-state imaging element differs in the position of an electrode pad formed on the wiring board since the electrical connection form between the wiring board differs between wire bonding and bump bonding. Thus, where solid-state imaging elements common in platform are used, a wiring board for mounting a frontside incident type solid-state imaging element and a wiring board for mounting backside incident type solid-state imaging element are required to be prepared. Thus, a problem in terms of manufacturing cost has been imposed.

Under the above circumstances, the present invention is to provide a wiring board high in general versatility and capable of mounting either the frontside incident type solid-state imaging element and the backside incident type solid-state imaging element and also a solid-state imaging device using the wiring board.

### Means for Solving the Problem

The wiring board of the present invention is a wiring board having a to-be-arranged region at which a solid-state imaging element is arranged and provided with a plurality of first electrode pads formed inside the to-be-arranged region and a plurality of second electrode pads formed outside the to-be-arranged region, each of which is electrically connected to each of the first electrode pads.

On the wiring board, a plurality of first electrode pads are formed inside a to-be-arranged region and a plurality of second electrode pads are formed outside the to-be-arranged region. Therefore, where a backside incident type solid-state imaging element is mounted, the terminal electrodes thereof can be electrically connected to the first electrode pads by bump bonding. On the other hand, where a frontside incident type solid-state imaging element is mounted, the terminal electrodes thereof are electrically connected to the second electrode pads by wire bonding. Further, since the mutually corresponding first electrode pads and the second electrode pads are electrically connected, common input and output signals can be transmitted. Therefore, such a wiring board is provided that is high in general versatility and capable of mounting either the frontside incident type solid-state imaging element and the backside incident type solid-state imaging element.

Further, the wiring board of the present invention is preferably provided with positioning marks indicating a to-be-arranged region. According to the wiring board, a solid-state imaging element can be accurately arranged on the to-be-arranged region on the basis of the positioning marks.

The solid-state imaging device of the present invention is constituted with a solid-state imaging element arranged at a to-be-arranged region of a wiring board; the wiring board is provided with a plurality of first electrode pads formed inside the to-be-arranged region and a plurality of second electrode pads formed outside the to-be-arranged region, each of which is electrically connected to each of the first electrode pads; the solid-state imaging element is provided with a light detecting portion disposed on a face opposing a light receiving face and terminal electrodes electrically connected to the light detecting portion; the light detecting portion is provided with a vertical charge transfer portion, horizontal charge transfer portions disposed on both sides of the vertical charge transfer portion and a signal reading portion disposed at each of the horizontal charge transfer portions to read a signal from the horizontal charge transfer portion; and the terminal electrodes are electrically connected to the first electrode pads by bump bonding.

The solid-state imaging device of the present invention is constituted with a solid-state imaging element arranged at a to-be-arranged region of a wiring board; the wiring board is provided with a plurality of first electrode pads formed inside the to-be-arranged region and a plurality of second electrode pads formed outside the to-be-arranged region, each of which is electrically connected to each of the first electrode pads; the solid-state imaging element is provided with a light detecting portion disposed on a light receiving face and terminal electrodes electrically connected to the light detecting portion; the light detecting portion is provided with a vertical charge transfer portion, horizontal charge transfer portions disposed on both ends of the vertical charge transfer portion and a signal reading portion disposed at each of the horizontal charge transfer portions to read a signal from the horizontal charge transfer portion; and the terminal electrodes are electrically connected to the second electrode pads by wire bonding.

The application of the above-described wiring board of the present invention makes it possible to provide a frontside incident type solid-state imaging device and a backside incident type solid-state imaging device at a moderate price.

Further, the solid-state imaging device of the present invention is preferably provided with an electrical insulating layer disposed between a wiring board and a solid-state imaging element at a to-be-arranged region. In the above-described solid-state imaging device, the electrical insulating layer is able to electrically insulate a frontside incident type solid-state imaging element and second electrode pads of the wiring board. Therefore, it is possible to transmit input and output signals to a frontside incident type solid-state imaging device via the wiring board without fail.

### Effect of the Invention

According to the present invention, it is possible to provide a wiring board high in general versatility and capable of mounting either the frontside incident type and backside incident type, and also a solid-state imaging device using the wiring board.

### Brief Description of the Views

Fig. 1 is a plan view showing one embodiment of the wiring board of the present invention.
Fig. 2 is a cross sectional view taken along line II-II of the wiring board in Fig. 1.
Fig. 3 is a view showing one example of a solid-state imaging element having the arrangement of terminal electrodes interchangeable in inputting and outputting depending on the frontside incident type or backside incident type.
Fig. 4 is a plan view showing one embodiment of the solid-state imaging device of the present invention.
Fig. 5 is a cross sectional view taken along line V-V of the solid-state imaging device in Fig. 4.
Fig. 6 is a plan view showing another embodiment of the solid-state imaging device of the present invention.
Fig. 7 is a cross sectional view taken along line VII-VII of the solid-state imaging device in Fig. 6.

### Description of Symbols

1: wiring board
2: solid-state imaging element
3: backside incident type solid-state imaging device
4: frontside incident type solid-state imaging device
11: substrate
12: first electrode pad
13: second electrode pad
14: positioning mark
15: internal wiring
16: external terminal
22, 35, 44: terminal electrodes
31: conductive bump
41: conductive wire
42: electrical insulating layer

### Best Modes for Carrying Out the Invention

Findings of the present invention will be easily understood by considering a detailed description given below with reference to the attached views presented only for illustration. Then, a description will be given for embodiments of the present invention with reference to the attached views. Wherever possible, the same part is given the same reference symbol to omit a redundant description.

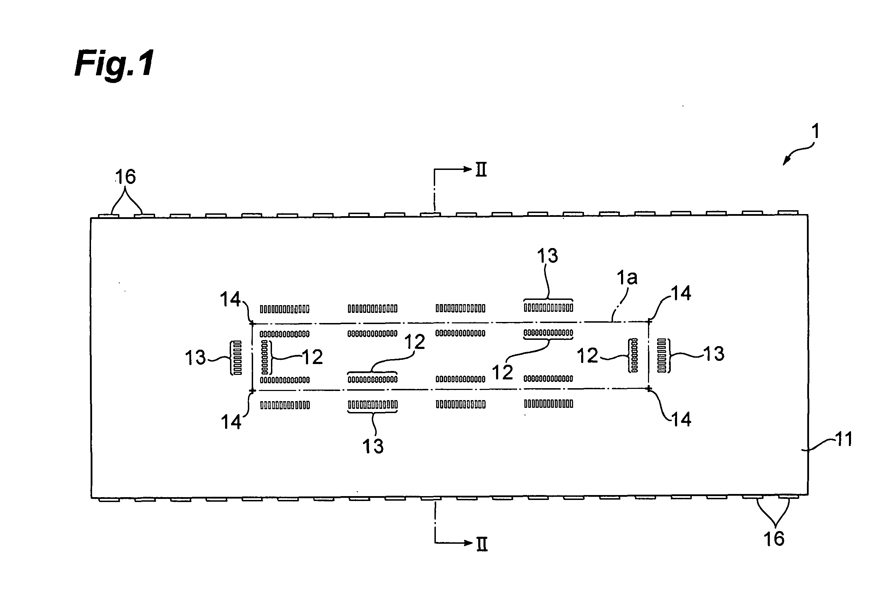

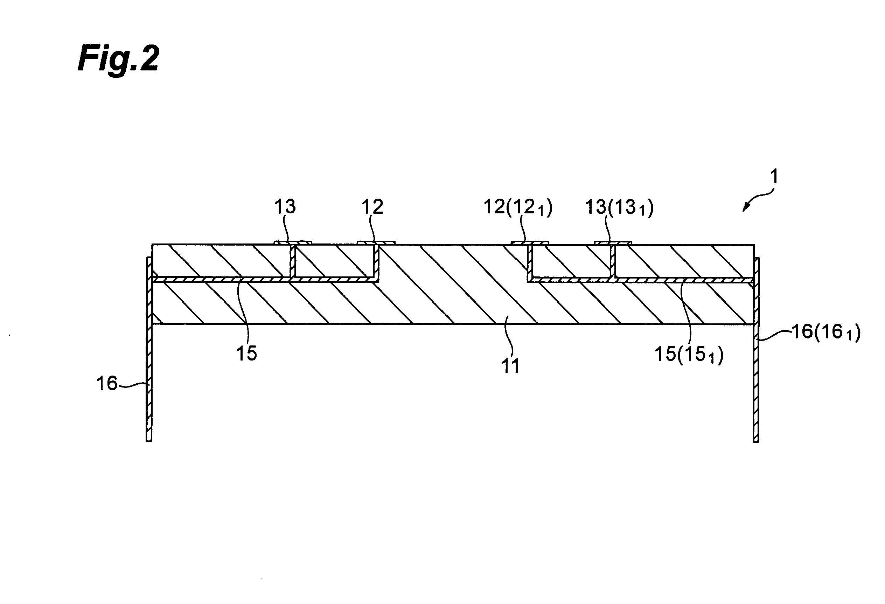

The wiring board of the present embodiment will be described with reference to Fig. 1 and Fig. 2. Fig. 1 is a plan view showing one embodiment of the wiring board of the present invention. Fig. 2 is a cross sectional view taken along line II-II of the wiring board in Fig. 1. The wiring board 1 is provided with a rectangular ceramic multi-layered substrate 11 when viewed from above (the ceramic material is, for example, aluminum nitride). First electrode pads 12, second electrode pads 13 and positioning marks 14 are formed at predetermined positions on the front side thereof. Further, inside the substrate 11, an internal wiring 15 is formed, and on the side face thereof, an external terminal 16 is formed.

A plurality of the first electrode pads 12 are formed inside a to-be-arranged region 1a on the front side of the substrate 11. In this instance, the to-be-arranged region 1a is a region where a solid-state imaging element is arranged. The region is formed in a rectangular shape when viewed from above, extending to a longitudinal direction of the substrate 11 approximately at the center of the substrate 11. The first electrode pads 12 are arranged in line along the peripheral part of the to-be-arranged region 1a which is rectangular in shape. It is noted that the first electrode pads 12 are to be bump-bonded to terminal electrodes of a backside incident type solid-state imaging element, and positions at which the first electrode pads 12 are formed correspond to those at which the thus arranged terminal electrodes of the backside incident type solid-state imaging element are formed.

A plurality of the second electrode pads 13 are formed outside the to-be-arranged region 1a on the front side of the substrate 11. More specifically, these electrode pads are arranged in line outside the to-be-arranged region 1a so as to surround the rectangular to-be-arranged region 1a. Further, the second electrode pads 13 are formed in the same number as the first electrode pads 12. It is noted that the second electrode pads 13 are to be wire-bonded to the terminal electrodes of a frontside incident type solid-state imaging element and the positions at which the second electrode pads 13 are formed to correspond to those at which the thus arranged terminal electrodes of the frontside incident type solid-state imaging element are formed. The first electrode pads 12 and the second electrode pads 13 are formed with a conductive material, for example, metal, by methods such as printing and sputtering.

The positioning marks 14 are formed to indicate a to-be-arranged region 1a at which a solid-state imaging element is arranged. Specifically, the positioning marks 14 are formed at four positions between the thus arranged first electrode pads 12 and the thus arranged second electrode pads 13. Where a solid-state imaging device is arranged, the solid-state imaging element is fixed in such a manner that four corners of the element are respectively in alignment with the four positioning marks 14. The positioning marks 14 may be formed in the same manner as the first electrode pads 12 and the second electrode pads 13 by methods such as printing and sputtering.

The mutually corresponding first electrode pads 12 and second electrode pads 13 are electrically connected by internal wirings 15. Further, the internal wirings 15 are electrically connected individually to a plurality of external terminals 16 formed so as to extend from the side face of the substrate 11 to below. As a result, common input and output signals are to be transmitted to the thus corresponding first electrode pads 12 and second electrode pads 13 via the internal wirings 15 and the external terminals 16. For example, where a first electrode pad 12₁ is electrically connected to a second electrode pad 13₁ and both of them are electrically connected to an external terminal 16₁, upon input of a vertical charge transfer pulse from the external terminal 16₁, the vertical charge transfer pulse is transmitted to both of the first electrode pad 12₁ and the second electrode pad 13₁ via the internal wiring 15₁.

Therefore, the first electrode pads 12 and the second electrode pads 13 electrically connected by the internal wirings 15 are appropriately determined according to arrangements of the respective terminal electrodes of a frontside incident type solid-state imaging element and a backside incident type solid-state imaging element arranged on a wiring board. Where the arrangements of the respective terminal electrodes of the frontside incident type solid-state imaging element and the backside incident type solid-state imaging element arranged on a wiring board 1 are interchangeable in inputting and outputting depending on the frontside incident type or backside incident type, the first electrode pads 12 and the second electrode pads 13 which oppose each other behind the outer periphery of a rectangular to-be-arranged region 1a are connected by the internal wirings 15. In this instance, adjacent electrode pads 12, 13 are connected to each other, thus making it possible to simplify the handling of the internal wirings 15.

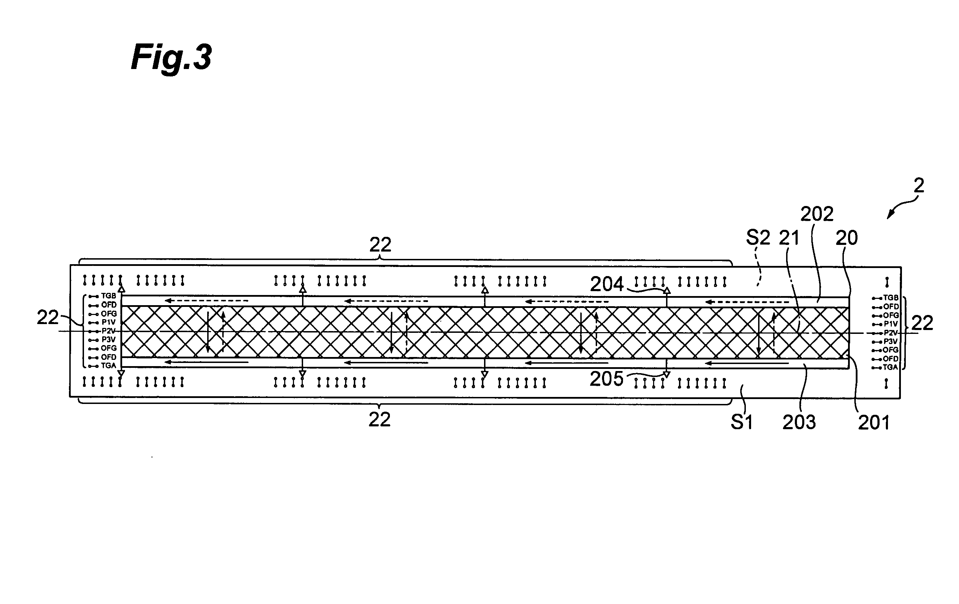

In this instance, a description will be given for a frontside incident type solid-state imaging element and a backside incident type solid-state imaging element in which terminal electrodes are arranged so as to be interchangeable in inputting and outputting depending on the frontside incident type or backside incident type. Fig. 3 is a view showing an example of the solid-state imaging element in which terminal electrodes are arranged so as to be interchangeable in inputting and outputting depending on the frontside incident type or backside incident type. The solid-state imaging element 2 is provided with a CCD 20, and the CCD 20 has a vertical charge transfer portion 201 and horizontal charge transfer portions 202, 203 on both sides of the vertical charge transfer portion 201. Further, signal reading portions 204, 205 are disposed respectively on the horizontal charge transfer portions 202, 203 so as to read a signal from either the signal reading portions 204, 205. Still further, terminal electrodes 22 (P1V, P2V, P3V, TGA, TGB, OFG, OFD, P1H, P2H, OS, OD, RG, RD and others (some of them are not illustrated)) are arranged so as to give a line symmetry on the basis of a center line 21 extending to a longitudinal direction of the solid-state imaging element 2. Thereby, an input/output interchangeable device which does not differ in the charge transfer direction (the solid line arrow indicates the transfer direction where the terminal electrodes are arranged on a wiring board from a backside S2, and the dotted line arrow indicates the transfer direction where they are arranged on the wiring board from a front side S1) and in the position at which signals are input and output, irrespective of whether the electrodes are arranged on the wiring board from the backside S2 or they are arranged on the wiring board from the front side S1, reversed around the center line 21. If the terminal electrodes 22 are arranged so as to be a line symmetry with respect to the center line extending to a width direction of the solid-state imaging element 2, the element can also be interchangeable in inputting and outputting depending on the frontside incident type or backside incident type. In this case, the horizontal charge transfer portion may be formed only on one end of the vertical charge transfer portion.

As described above, a plurality of the first electrode pads 12 are formed inside the to-be-arranged region 1a and a plurality of the second electrode pads 13 are formed outside the to-be-arranged region 1a on the wiring board 1. Therefore, where a backside incident type solid-state imaging element is mounted, the terminal electrodes thereof can be electrically connected to the first electrode pads 12 by bump bonding. On the other hand, where a frontside incident type solid-state imaging element is mounted, the terminal electrodes can be electrically connected to the second electrode pads 13 by wire bonding. Further, since the mutually corresponding first electrode pads 12 and second electrode pads 13 are electrically connected, it is possible to transmit common input and output signals. Therefore, it is possible to provide the wiring board 1 high in general versatility and capable of mounting either the frontside incident type solid-state imaging element and the backside incident type solid-state imaging element.

Further, since the wiring board 1 is provided with positioning marks 14 indicating a to-be-arranged region 1a, it is possible to arrange accurately a solid-state imaging element at the to-be-arranged region 1a on the basis of the positioning marks 14.

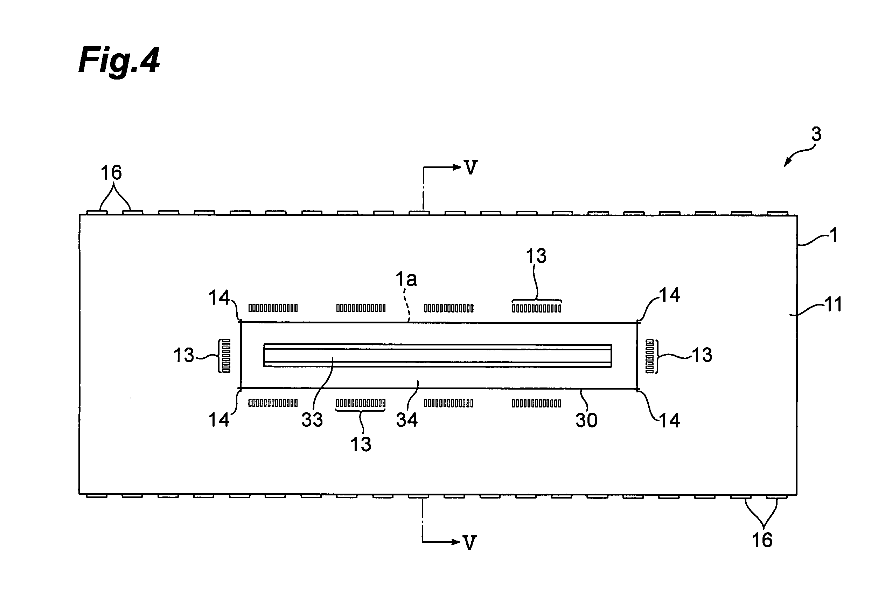

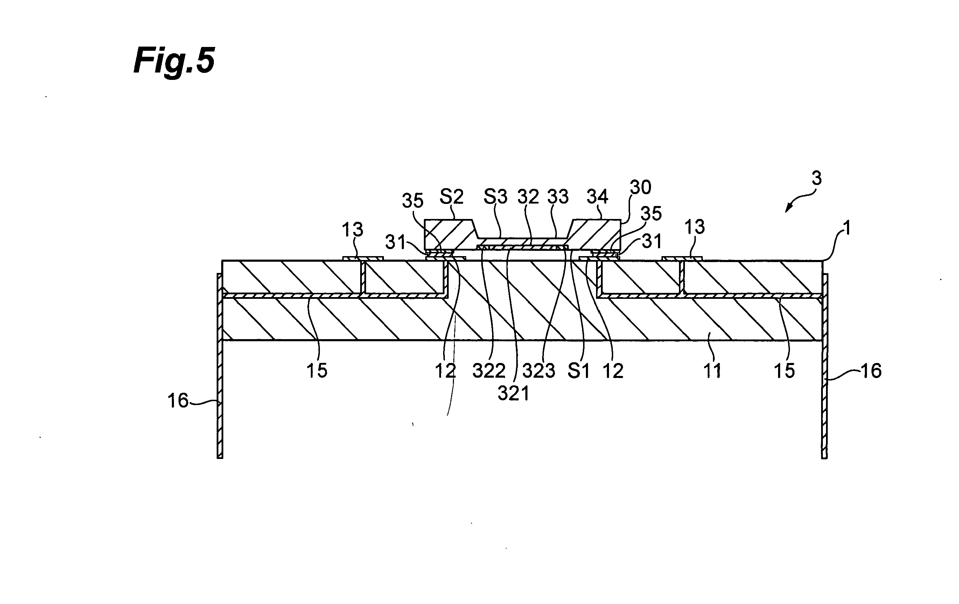

Then, a description will be given for one embodiment of the solid-state imaging device of the present invention with reference to Fig. 4 and Fig. 5. Fig. 4 is a plan view showing one embodiment of the solid-state imaging device of the present invention. Fig. 5 is a cross sectional view taken along line V-V of the solid-state imaging device in Fig. 4.

A backside incident type solid-state imaging device 3 is provided with a wiring board 1, a backside incident type solid-state imaging element 30 and a conductive bump 31. The backside incident type solid-state imaging device 3 is a device mounted on the wiring board of the above described one embodiment, the backside incident type solid-state imaging element having terminal electrodes arranged so as to be interchangeable in inputting and outputting depending on the frontside incident type or backside incident type as shown in Fig. 3.

The backside incident type solid-state imaging element 30 is formed in a rectangular shape when viewed from above, corresponding in size to a to-be-arranged region 1a of the wiring board 1. The backside incident type solid-state imaging element 30 is constituted, for example, with a P+ layer of silicon and a P epi-layer formed thereon. A CCD 32 is formed at a part of the front side layer on the front side S1 thereof as a light detecting portion. The CCD 32 is provided, for example, with a plurality of pixels of 1024 pixels × 128 pixels arranged in a two-dimensional manner. Further, the CCD 32 is provided with a vertical charge transfer portion 321 and a horizontal charge transfer portions 322, 323, as shown in Fig. 3.

A backside incident type solid-state imaging element 30 is also provided with a thinned portion 33 formed which is thinned by etching a region of the backside S2 opposing the CCD 32. The thinned portion 33 is formed having a flat light receiving face S3, the etched face of which is rectangular. And, the light receiving face S3 is formed so as to be approximately similar in size to the CCD 32.

The thickness of the backside incident type solid-state imaging element 30 is approximately from 10 to 100 µm, for example, at the thinned portion 33 and from 300 to 600 µm at an outer peripheral part of the thinned portion 33. It is noted that the outer peripheral part 34 of the thinned portion 33 is a part which is thicker than the thinned portion 33 on the periphery of the thinned portion 33 in the backside incident type solid-state imaging element 30.

A terminal electrode 35 is formed at a peripheral part on the front side S1 of the backside incident type solid-state imaging element 30. The terminal electrode 35 is arranged so as to be interchangeable in inputting and outputting depending on the frontside incident type or backside incident type as shown in Fig. 3. Further, the terminal electrode 35 is electrically connected to the CCD 32 by a wiring (not illustrated). Still further, the backside S2 of the backside incident type solid-state imaging element 30 is covered with an accumulation layer (not illustrated) for its entirety including the light receiving face S3. The accumulation layer has the same conductive type as that of the backside incident type solid-state imaging element 30 but higher in concentration of impurities than the backside incident type solid-state imaging element 30.

The backside incident type solid-state imaging element 30 is implemented on a wiring board 1 by bump bonding. More specifically, the wiring board 1 is arranged so as to oppose the front side S1 of the backside incident type solid-state imaging element 30. In this case, the backside incident type solid-state imaging element 30 is adjusted for the position by the positioning marks 14 on the wiring board 1 and arranged at the to-be-arranged region 1a. Further, the terminal electrodes 35 formed on the front side S1 of the backside incident type solid-state imaging element 30 are connected to the first electrode pads 12 formed inside the to-be-arranged region 1a on the wiring board 1 individually via the conductive bumps 31.

The wiring board 1 is also provided with a package (not illustrated) which is opened at the center so as to cover the backside incident type solid-state imaging element 30. A window member (not illustrated) is fitted into an opening part of the package.

As described above, since the wiring board 1 high in general versatility is used, it is possible to provide the backside incident type solid-state imaging device 3 at a moderate price.

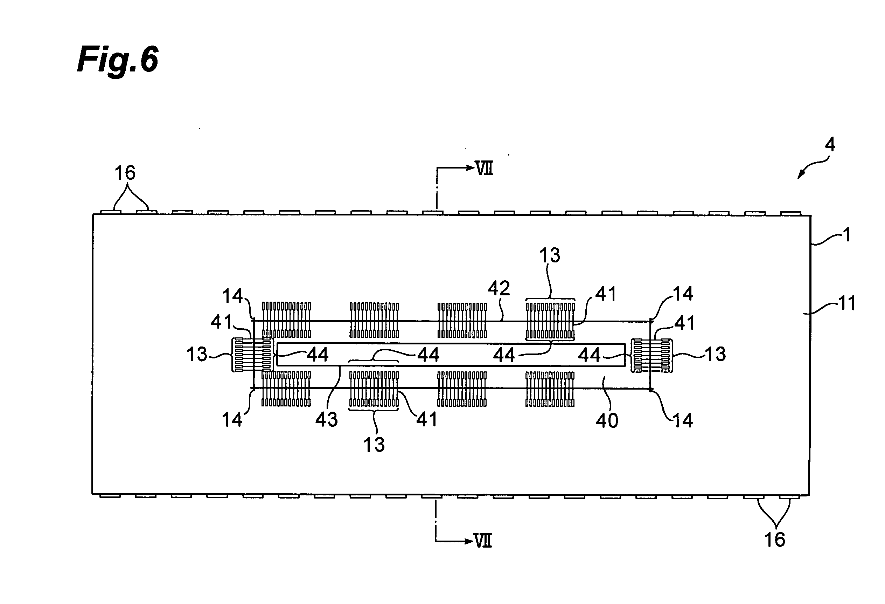

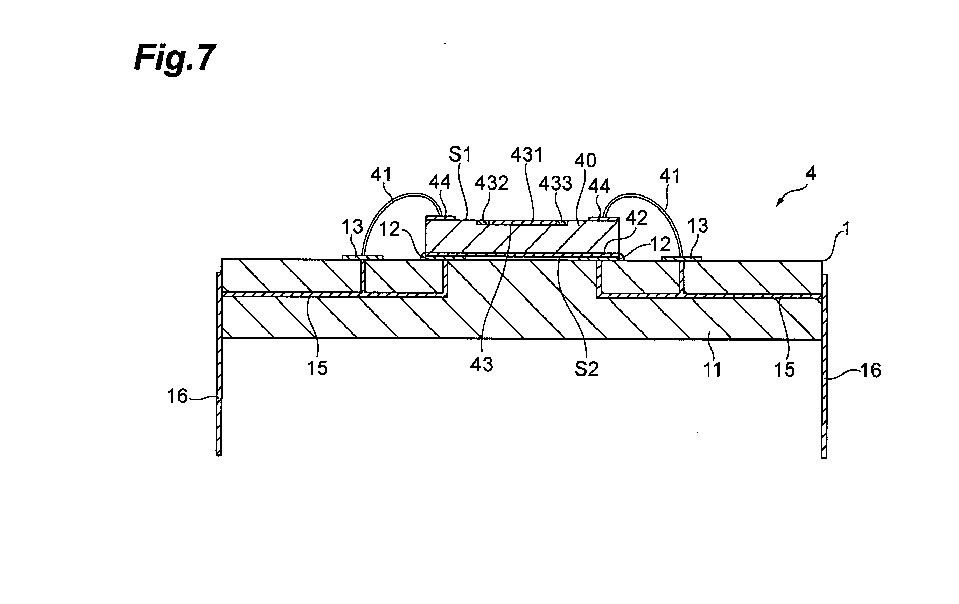

Then, a description will be given for another embodiment of the solid-state imaging device of the present invention with reference to Fig. 6 and Fig. 7. Fig. 6 is a plan view showing another embodiment of the solid-state imaging device of the present invention. Fig. 7 is a cross sectional view taken along line VII-VII of the solid-state imaging device in Fig. 6.

A frontside incident type solid-state imaging device 4 is provided with a wiring board 1, a frontside incident type solid-state imaging element 40, a conductive wire 41 and an electrical insulating layer 42. The frontside incident type solid-state imaging device 4 is provided with a frontside incident type solid-state imaging element being an interchangeable in inputting and outputting depending on the frontside incident type or backside incident type as shown in Fig. 3 on the wiring board according to the above-described one enbodiment.

The frontside incident type solid-state imaging element 40 differs from the backside incident type solid-state imaging element 30 in that no thinned portion is formed, and is identical in the other constitutions to the backside incident type solid-state imaging element 30. More specifically, the frontside incident type solid-state imaging element 40 is formed in a rectangular shape when viewed from above, corresponding in size to a to-be-arranged region 1a of the wiring board 1. A CCD 43 is formed at a part of the front side layer on the front side S1 thereof as a light detecting portion. The CCD 43 is provided, for example, with a plurality of pixels of 1024 pixels × 128 pixels arranged in a two-dimensional manner. Further, the CCD 43 is provided with a vertical charge transfer portion 431 and a horizontal charge transfer portions 432, 433 as shown in Fig. 3.

The thickness of the frontside incident type solid-state imaging element 40 is, for example, approximately from 300 to 600 µm. Terminal electrodes 44 are formed at a peripheral part on the front side S1 of the frontside incident type solid-state imaging element 40. The terminal electrodes 44 are arranged so as to be interchangeable in inputting and outputting depending on the frontside incident type or of backside incident type as shown in Fig. 3. Further, the terminal electrodes 44 are electrically connected to the CCD 43 by a wiring (not illustrated).

The frontside incident type solid-state imaging element 40 is mounted on the wiring board 1 by wire bonding. More specifically, the wiring board 1 is arranged so as to oppose the backside S2 of the frontside incident type solid-state imaging element 40. In this instance, the frontside incident type solid-state imaging element 40 is adjusted for the position by the positioning marks 14 on the wiring board 1 and arranged at the to-be-arranged region 1a. Further, an electrical insulating layer 42 is formed between the frontside incident type solid-state imaging element 40 and the wiring board 1. The electrical insulating layer 42 is formed in a rectangular shape when viewed from above, having such a size that covers the backside of the frontside incident type solid-state imaging element 40. The terminal electrodes 44 formed on the front side S1 of the frontside incident type solid-state imaging element 40 are electrically connected to the second electrode pads 13 formed outside the to-be-arranged region 1a on the wiring board 1 via the conductive wires 41.

The wiring board 1 is also provided with a package (not illustrated) which is opened at the center so as to cover the frontside incident type solid-state imaging element 40. A window member (not illustrated) is fitted into an opening part of the package.

As described above, since the wiring board 1 high in general versatility is used, it is possible to provide the frontside incident type solid-state imaging device 4 at a moderate price.

Further, according to the frontside incident type solid-state imaging device 4, since the frontside incident type solid-state imaging element 31 is mounted on the wiring board 1 via the electrical insulating layer 42, it is possible to electrically insulate the frontside incident type solid-state imaging element 40 from the second electrode pads 13 disposed on the wiring board 1. Thus, input and output signals can be transmitted to the frontside incident type solid-state imaging device 4 via the wiring board 1 without fail.

Still further, the solid-state imaging device of the present invention shall not be limited to the embodiments described above. The backside incident type solid-state imaging element mounted on the wiring board may include not only devices which are partially thinned but also those that are totally thinned in place of the former.

### Industrial Applicability

The present invention is able to provide a wiring board high in general versatility capable of mounting either a frontside incident type solid-state imaging element and a backside incident type solid-state imaging element and a solid-state imaging device using the wiring board.

## Claims

1. A wiring board having a to-be-arranged region at which a solid-state imaging element is arranged, including;
a plurality of first electrode pads formed inside the to-be-arranged region and
a plurality of second electrode pads formed outside the to-be-arranged region, each of which is electrically connected to each of the first electrode pads.

2. The wiring board according to claim 1 including;
positioning marks indicating the to-be-arranged region.

3. A solid-state imaging device in which a solid-state imaging element is arranged at a to-be-arranged region of a wiring board, wherein
the wiring board is provided with a plurality of first electrode pads formed inside the to-be-arranged region and a plurality of second electrode pads formed outside the to-be-arranged region, each of which is electrically connected to each of the first electrode pads;
the solid-state imaging element is provided with a light detecting portion disposed on a face opposing a light receiving face and a terminal electrode electrically connected to the light detecting portion;
the light detecting portion is provided with a vertical charge transfer portion, horizontal charge transfer portions disposed on both sides of the vertical charge transfer portion and a signal reading portion disposed at each of the horizontal charge transfer portions to read a signal from the horizontal charge transfer portion; and
the terminal electrodes are electrically connected to the first electrode pads by bump bonding.

4. A solid-state imaging device in which a solid-state imaging element is arranged at a to-be-arranged region on a wiring board, wherein
the wiring board is provided with a plurality of first electrode pads formed inside the to-be-arranged region and a plurality of second electrode pads formed outside the to-be-arranged region, each of which is electrically connected to each of the first electrode pads;
the solid-state imaging element is provided with a light detecting portion disposed on a light receiving face and a terminal electrode electrically connected to the light detecting portion;
the light detecting portion is provided with a vertical charge transfer portion, horizontal charge transfer portions disposed on both sides of the vertical charge transfer portion and a signal reading portion disposed at each of the horizontal charge transfer portions to read a signal from the horizontal charge transfer portion, and
the terminal electrodes are electrically connected to the second electrode pads by wire bonding.

5. The solid-state imaging device according to claim 4, wherein
an electrical insulating layer is disposed between the wiring board and the solid-state imaging element at the to-be-arranged region.
